# EUROPEAN PATENT APPLICATION

(11) **EP 3 890 173 A1**
(43) Date of publication of application: **06.10.2021**
(21) Application number: 20167169.0
(22) Date of filing: 31.03.2020
(51) Int. Cl.: H02M 1/12, H03H 7/42

(54) **FILTER SYSTEM FOR A CONVERTER CIRCUIT**

(71) Applicant: Siemens Aktiengesellschaft, 80333 München (DE)
(72) Inventor: Mondal, Gopal, 91058 Erlangen (DE)

(57) **Abstract**

Filter system for a power converter for converting between a first and a second voltage, the first voltage being a three-phase voltage, comprising
- a first and second filter stage arranged in series and connectable between the first voltage and a converter circuit, wherein
- the first filter stage comprises a first common mode filter, the first common mode filter being a three-phase filter with three coils arranged in the phases of the first voltage,
- the second filter stage comprises a second common mode filter, the second common mode filter being a single phase filter having a single coil,
- the second common mode filter is connected capacitively to all phases of the first voltage.

## Description

The present invention relates to an electrical filter system for a power converter circuit for converting between a first and a second voltage, the first voltage being a multi-phase, particularly a three-phase voltage. The invention also relates to a power converter comprising the power converter circuit and the filter system.

Many types of power converters, e.g. typical DC/AC converters with half-bridges supplying a DC input voltage in a pulse width modulation to generate an AC output produce electrical noise that is passed to a load or the grid and reduces voltage quality there which in turn may reduce performance or may even be hazardous to machinery.

Inductive elements, i.e. conductors may be used in filter systems for filtering the AC voltage signal. Both differential mode noise, created from circulating current and common mode noise are points of consideration when building a filter system. Typically common mode filters are built using discrete coupled inductors. A higher number of inductors improves the noise reduction but increases the length of the busbars and thus the overall size of the filter.

While the bulk and weight of inductive and capacitive elements depends on the specific converter parameters it is typical for these elements to make up a considerable part of the overall weight and size of the converter.

The object of the present invention is to provide a filter system that allows reducing the size of the filter system.

A filter system in accordance with the invention is suitable for a converter circuit for converting between a first and a second voltage, the first voltage being a three-phase voltage. It comprises a first and second filter stage arranged in series and connectable between the first voltage and the converter circuit.

The first filter stage comprises a first common mode filter, the first common mode filter being a three-phase filter with three coils arranged in the phases of the first voltage. The second filter stage comprises a second common mode filter, the second common mode filter being a single phase filter having a single coil. The second common mode filter is connected capacitively to all phases of the first voltage.

Compared to filter systems that use two three phase common mode filters this filter system advantageously has a reduced size. The filter system is applicable to any electrical converter between a three-phase voltage and another voltage that may be single-phase or multi-phase. The converter may for example be a three-phase rectifier. The filter system is applicable to be arranged between the converter circuit which effects the power conversion and the three phase network. The three phase network can for example be an electrical grid.

Further features that may be added alone or together in exemplary embodiments of the invention include:
The coils of the first and second common mode filters may be arranged on a common magnetic core with all coils being arranged to have an identical winding direction. The coils are in other words positively coupled. This common magnetic core has the general structure of a single closed loop. It can be for example a torus, a ring or it can be of rectangular shape. Advantageously this combined structure saves space as individual magnetic cores have fewer windings on them but require their own mechanical structure for use in a circuit. The common magnetic core on the other only requires this mechanical structure once. In addition smaller or fewer busbars used for the connections between individual inductors are required. A reduction of the busbars will also reduce the parasitic components in the circuit.

The second filter stage may comprise a third common mode filter, the third common mode filter being a three-phase filter with three coils arranged in the phases of the first voltage.

If the coils of the first and second common mode filters are arranged on a common magnetic core, the coils of the third common mode filter may also be arranged on the common magnetic core with all coils being arranged to have an identical winding direction. As the common magnetic core is a closed loop, all coils are positively coupled. Coupling the coils increases the overall inductance thereby allowing a reduction of the number of windings for each of the coils, reducing the size of the inductor and coils.

The coils of the first common mode filter may have a lower number of windings than the coils of the third common mode filter. A lower number of windings or less inductance is required because the second filter stage sufficiently filters the lower harmonics which require a higher inductance.

To complement the filter system, a first three phase differential mode filter may be arranged in series with the first common mode filter. Also, a second three phase differential mode filter may be arranged in series with the third common mode filter.

The second common mode filter may be serially connected to a first capacitor and the first capacitor in turn may be serially connected to a parallel connection of three second capacitors that are each connect to a respective phase. In this way the second common mode filter is capacitively connected to all phases.

The common magnetic core may be made from a ferromagnetic material such as iron, nickel, cobalt, an alloy therefrom, or the like. It may also be made from sheets containing one of the before-mentioned components which are insulated against each other. It therefore forms a magnetic circuitry for guiding magnetic flux.

A power converter for converting between a first and a second voltage, the first voltage being a three-phase voltage, may be constructed from a converter circuit for voltage conversion between the first and second voltage in series with such filter system.

Such a power converter may be suitable for a second voltage that is a DC voltage, either of a DC voltage network or as a DC link. In this case the second voltage may comprise a voltage midpoint between the poles of the DC voltage and the second common mode filter may be connected to this midpoint, advantageously reducing the effect of parasitic capacitances.

Embodiments of the present invention are now described with reference to the accompanying drawings to which the invention is not limited.
Fig. 1 illustrates a power converter with a filter system according to an embodiment of the invention;
Figs. 2 and 3 illustrate common magnetic cores with coils for use in the filter system;
Fig. 4 illustrates a power converter with a second filter system according to a further embodiment of the invention;
Figs. 5 and 6 illustrate common magnetic cores with coils for use in the second filter system;
Fig. 7 illustrates simulated CM currents;

The illustrations of the drawings are in schematic form. It is noted that in different figures, similar or identical elements use the same reference signs.

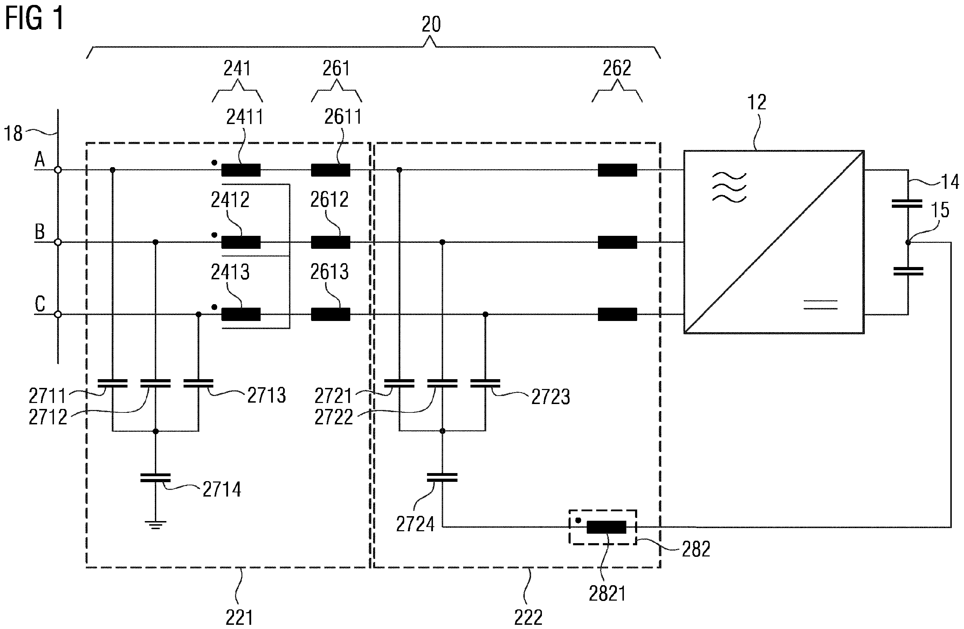

Fig. 1 illustrates a power converter 10. The power converter 10 comprises a converter circuit in the form of a three-phase rectifier 12 of a type known in the art. In this example the three-phase rectifier 12 is connected on the DC side to a DC link 14 having a voltage midpoint 15. The three-phase rectifier 12 may therefore be only a part of a three phase to three phase voltage converter that is formed by complementing the three-phase rectifier 12 with a three-phase inverter which is not shown in Fig. 1. On the other hand the DC link 14 may be connected to a DC voltage network which is not shown in Fig. 1. The three-phase rectifier 12 of this example is not limited to a one-directional flow of power and it may work as an inverter from its DC side to its AC side.

In addition to three-phase rectifier 12 the power converter of fig. 1 comprises a filter system 20 comprising a first filter stage 221 and a second filter stage 222 which are connected in series between the three-phase side of the three-phase rectifier 12 and a three-phase voltage network such as AC grid 18.

The first filter stage 221 is arranged closest to AC grid 18 and comprises a first three phase common mode inductor 241 having three coils 2411...2413. Each of the coils 2411...2413 is serially connected in one of the phase lines 191...193. Coils 2411...2413 are positively coupled.

In a serial connection to the first three phase common mode inductor 241 the first filter stage 221 comprises a first differential mode inductor 261 having three coils 2611...2613 that are arranged one to a phase line 191...193 similar to coils 2411...2413.

On the grid side of the first three phase common mode inductor 241 each of the phase lines 191...193 is connected to one side of one of three first differential mode capacitors 2711...2713. The other sides of the first differential mode capacitors 2711...2713 are interconnected and connect to another first differential mode capacitor 2714. The other side of this first differential mode capacitor 2714 is connected to ground.

The second filter stage 222 is arranged between the first filter stage 221 and the three phase rectifier 12. It comprises a second differential mode inductor 262 having three coils 2621...2623 that are arranged one to a phase line 191...193 similar to coils 2511...2513.

Effectively a series connection of one of the coils of each of the first common mode inductor 241 and the first and second differential mode inductors 261, 262 is arranged in each phase line 191...193 between the phases of AC grid 18 and the three-phase rectifier 12.

On the grid side of the second three phase differential mode inductor 262 each of the phase lines 191...193 is connected to one side of one of three second differential mode capacitors 2721...2723. The other sides of the second differential mode capacitors 2721...2723 are interconnected and connect to another second differential mode capacitor 2724. The other side of this second differential mode capacitor 2724 is connected to a second common mode inductor 282. The second common mode inductor 282 is a single phase inductor having a single coil 2821. On the side facing away from the second differential mode capacitor 2724 it is connected to the midpoint 15 of the DC link 14.

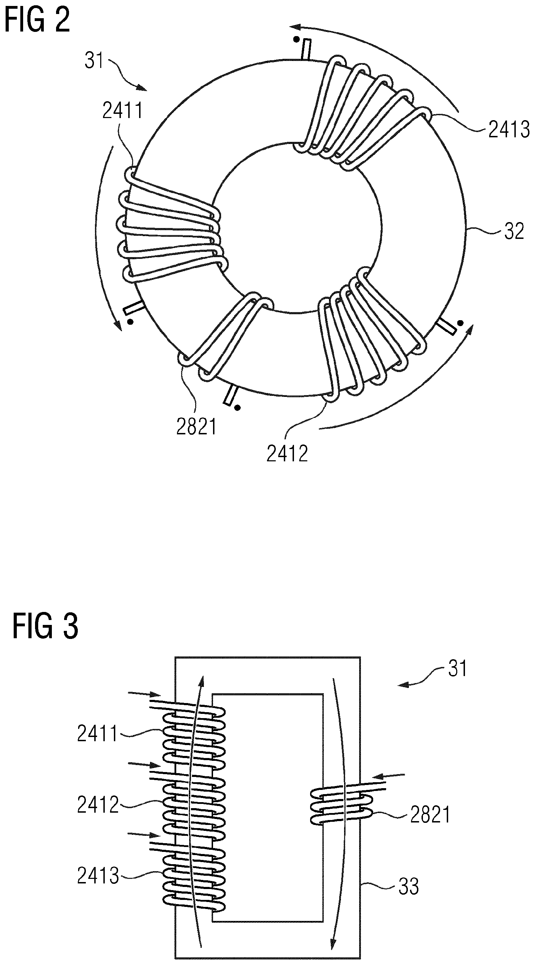

The first and second common mode inductors 241, 282 are actually built as a single common mode inductor 31. Two embodiments for this inductor are shown in figs. 2 and 3. The embodiment of fig. 2 uses a toroidal or ring-shaped common magnetic core 32 that carries the common mode coils 2411...2413, 2821. The common mode coils 2411...2413, 2821 are all arranged to have the same winding direction, positively coupling all of them. The embodiment of fig. 3 uses a rectangular common magnetic core 33 that carries the common mode coils 2411...2413, 2821.

The size that is required for the common mode inductors 241, 282 in this example is advantageously reduced as the second filter stage 222 only uses a single phase inductor 282 and it is further reduced by having all coils arranged on a common magnetic core 32, 33, saving room by reducing busbar length and removing elements required to connect multiple magnetic cores to the circuit. Reducing busbar lengths will in turn reduce parasitic elements of the circuits such as parasitic capacitance.

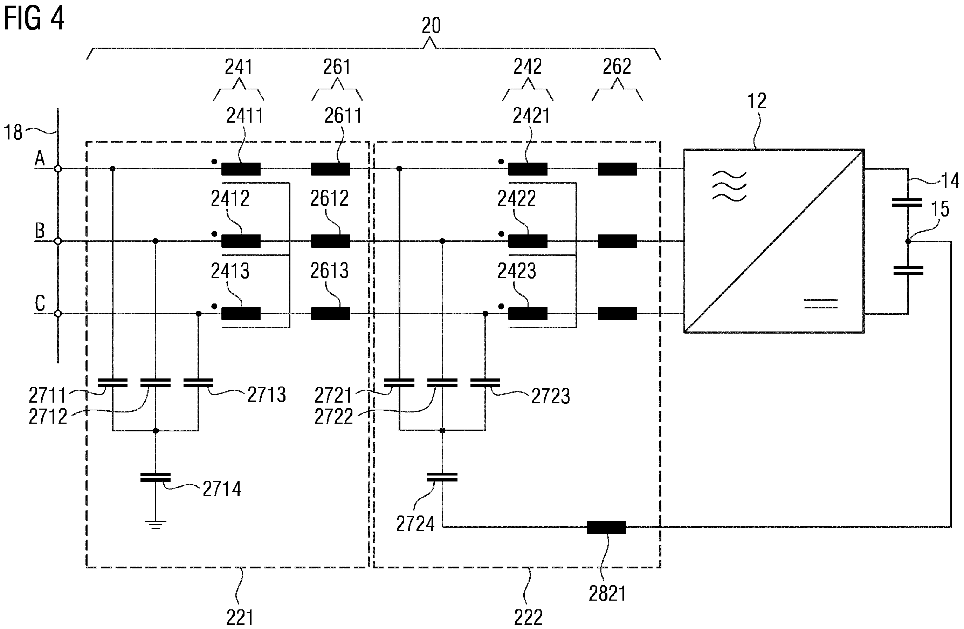

A second embodiment of a power converter 40 is shown in fig. 4. Power converter 40 comprises all the elements of power converter 10. In addition, power converter 40 comprises a third common mode inductor 242. The third common mode inductor 242 is a three phase inductor having three coils 2421...2423. Each of the coils 2421...2423 is serially connected in one of the phase lines 191...193. As with the first common mode inductor 241, coils 2421...2423 are positively coupled.

In power converter 40, a series connection of one of the coils of each of the first and third common mode inductors 241, 242 and the first and second differential mode inductors 261, 262 is arranged in each phase line 191...193 between the phases of AC grid 18 and the three-phase rectifier 12.

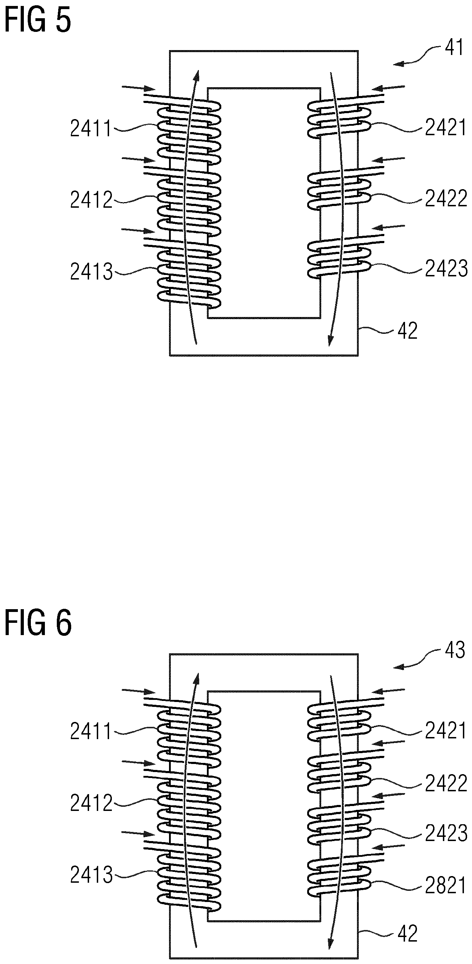

In power converter 40, the first and third common mode inductors 241, 242 may be built as a single common mode inductor 41. An embodiment for this inductor 41 is shown in fig. 5. The embodiment of fig. 5 uses rectangular common magnetic core 42 that carries the common mode coils 2411...2413, 2421...2423. The common mode coils 2411...2413, 2821 are all arranged to have the same winding direction, positively coupling all of them. Similarly to fig. 2, a toroidal shape may also be used for common magnetic core 42.

Alternatively, the first, second and third common mode inductors 241, 242, 282 may be built as a single common mode inductor 43. An embodiment for this inductor 43 is shown in fig. 6. The embodiment of fig. 5 uses rectangular common magnetic core 42 that carries the common mode coils 2411...2413, 2421...2423, 2821. Again, the common mode coils 2411...2413, 2421...2423, 2821 are all arranged to have the same winding direction, positively coupling all of them. Again, combining the common mode inductors reduces the size that is required for the filter stages 221, 222.

In addition to reducing the parts needed to setup multiple discrete common mode inductors the described setup also reduces the number of windings the coils need as coupling the coils increases the individual inductance, thereby further reducing the size needed to set up the inductors 41, 43.

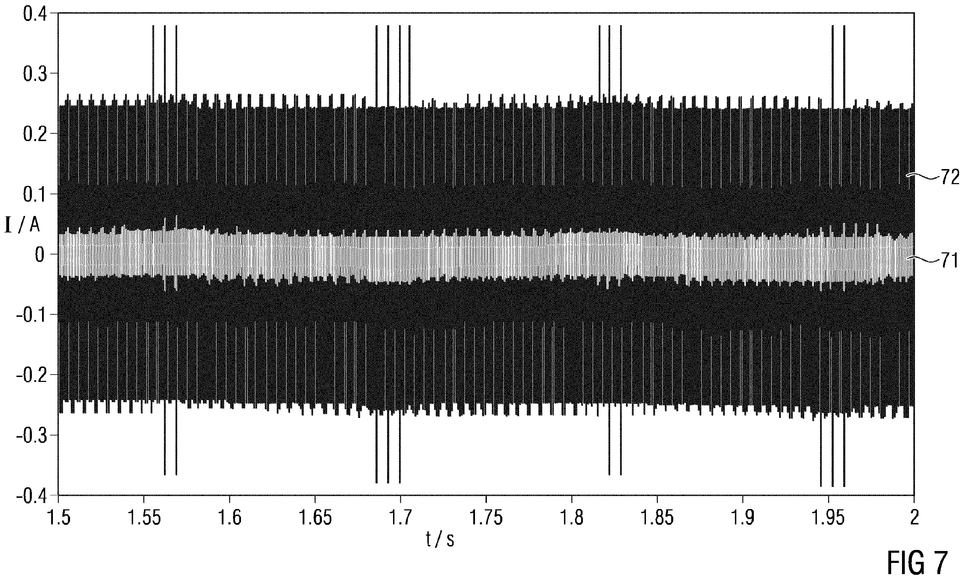

Fig. 7 shows a simulation result for a power converter 10 compared to a similar converter using non-coupled common mode inductors. It may be seen from fig. 7 that the common mode noise 71 of power converter 10 is lower by a factor of around five than the common mode noise 72 of the other converter.

### Reference Signs

- 10, 40: power converter
- 12: three-phase rectifier
- 14: DC link
- 15: midpoint
- 18: AC grid
- 20: filter system
- 221: first filter stage
- 222: second filter stage
- 241: first common mode inductor
- 242: third common mode inductor
- 2411...2413: coils
- 261: first differential mode inductor
- 262: third differential mode inductor
- 2611...2613: coils
- 2421...2423: coils
- 191...193: phase lines
- 2711...2714: first differential mode capacitors
- 2721...2724: second differential mode capacitors
- 282: second common mode inductor
- 2821: coil
- 31: common mode inductor
- 32, 33: common magnetic core
- 41, 42: common magnetic core
- 43: inductor
- 71, 72: common mode noise

## Claims

1. Filter system (20) for a power converter (10, 40) for converting between a first and a second voltage, the first voltage being a three-phase voltage, comprising
- a first and second filter stage (221, 222) arranged in series and connectable between the first voltage and a converter circuit (12),
wherein
- the first filter stage (221) comprises a first common mode filter (241), the first common mode filter (241) being a three-phase filter with three coils (2411...2413) arranged in the phases of the first voltage,
- the second filter stage (222) comprises a second common mode filter (282), the second common mode filter (282) being a single phase filter having a single coil (2821),
- the second common mode filter (282) is connected capacitively to all phases (191...193) of the first voltage.

2. The filter system (20) of claim 1, wherein the coils (2411...2413, 2821) of the first and second common mode filters (241, 282) are arranged on a common magnetic core (32, 33, 41, 42) with all coils (2411...2413, 2821) being arranged to have an identical winding direction.

3. The filter system (20) of claims 1 or 2 wherein the second filter stage (222) comprises a third common mode filter (242), the third common mode filter (242) being a three-phase filter with three coils (2421...2423) arranged in the phases (191...193) of the first voltage.

4. The filter system (20) of claim 3 and claim 2 wherein the coils (2421...2423) of the third common mode filter (242) are arranged on the common magnetic core (32, 33, 41, 42) with all coils (2411...2413, 2421...2423, 282) being arranged to have an identical winding direction.

5. The filter system (20) of claim 4 wherein the coils (2421...2423) of the third common mode filter (242) have a lower number of windings than the coils (2411...2413) of the first common mode filter (241).

6. The filter system (20) of one of the preceding claims wherein a first three phase differential mode filter (261) is arranged in series with the first common mode filter (241).

7. The filter system (20) of one of the preceding claims wherein a second three phase differential mode (262) filter is arranged in series with the third common mode filter (242) .

8. The filter system (20) of one of the preceding claims wherein the second common mode filter (282) is serially connected to a first capacitor (2714) and the first capacitor (2714) is serially connected to a parallel connection of three second capacitors (2711...2713) that are each connect to a respective phase (191...193).

9. Power converter (10, 40) for converting between a first and a second voltage, the first voltage being a three-phase voltage, with a converter circuit (12) for voltage conversion between the first and second voltage in series with a filter system (20) of one of the preceding claims.

10. The power converter of claim 9 wherein the second voltage is a DC voltage with a midpoint (15) between the poles of the DC voltage and the second common mode filter (282) is connected to the midpoint (15).
